# EUROPÄISCHE PATENTSCHRIFT

(11) **EP 2 092 811 B1**
(45) Veröffentlichungstag und Bekanntmachung des Hinweises auf die Patenterteilung: **04.01.2017**
(21) Anmeldenummer: 07819660.7
(22) Anmeldetag: 07.11.2007
(51) Int. Cl.: H05K 3/10, H05K 7/06

(54) **DRAHTBESCHRIEBENE LEITERPLATTE**
WIRE-INSCRIBED PRINTED CIRCUIT BOARD
CARTE DE CIRCUITS IMPRIMÉS COUVERTE DE FILS

(30) Priorität: 08.11.2006 DE 102006052706
(43) Veröffentlichungstag der Anmeldung: 26.08.2009
(73) Patentinhaber: JUMATECH GmbH, 90542 Eckental (DE)
(72) Erfinder: WÖLFEL, Markus, 90542 Eckenthal (DE)
(74) Vertreter: Grünecker Patent- und Rechtsanwälte PartG mbB
(86) Internationale Anmeldenummer: PCT/EP2007/009650
(87) Internationale Veröffentlichungsnummer: WO 2008/055672

(56) Entgegenhaltungen:
- DE-A1-102005 003 370
- DE-C1- 10 108 168
- JP-A- 9 306 247
- JP-A- 54 068 986
- JP-A- 2001 155 548
- US-A- 5 323 534
- US-A- 5 598 627

## Beschreibung

Die vorliegende Erfindung betrifft eine drahtbeschriebene Leiterplatte, umfassend eine leitfähige Folie, vorzugsweise ein mit der leitfähigen Folie verbundenes Stabilisierungsmittel und zumindest einen Leitungsdraht, welcher mit wenigstens einem zur Ausbildung einer Anschlussstelle vorgesehenen Bereich elektrisch oder thermisch leitend verbunden ist.

Üblicherweise werden Signale und Ströme auf Leiterplatten in Leiterbahnen fortgeleitet, welche durch ein Ätzverfahren hergestellt sind, d.h. von einem auf einer Trägerplatte aufgebrachten leitfähigen, dünnen Flächenelement (z.B. Kupferfolie) werden zwischen den gewünschten Leiterbahnen liegende Bereiche abgeätzt, wodurch sich diskrete, voneinander isolierte Anschluss- und Leiterbahnenstrukturen auf der Oberfläche der Trägerplatte erzeugen lassen. Bei drahtbeschriebenen Leiterplatten werden hingegen Leitungsdrähte aus elektrisch leitfähigem Material zwischen als Anschlussstelle vorgesehenen Bereichen des leitfähigen, dünnen Flächenelements verlegt und beispielsweise zusammen mit diesem in Verbundbauweise in einem Block aus Isolierstoffmasse zur Ausbildung einer Leiterplatte verpresst. Neben der beschriebenen elektrischen Leitung können die in der Regel aus Metall bestehenden Leitungsdrähte auch für eine thermische Leitung eingesetzt werden, z.B. zum Abführen von Wärme aus wärmeempfindlichen elektronischen Bauteilen. Hierbei sind die thermischen Leitungsdrähte auf der den elektrischen Leitungsdrähten abgewandten Seite des leitfähigen Flächenelements im Bereich des entsprechenden elektronischen Bauteils angeordnet. Leiterplatten und Leitungsdrähte sind aus JP 54068986, JP09306247 und DE 101 08 168 C1 bekannt.

Die beispielsweise aus Kupfer bestehenden Leitungsdrähte weisen in der Regel eine Beschichtung, z.B. in Form eines Lackes, auf, um dem oxidativen Angriff des Kupfers an der Oberfläche - beispielsweise während der Lagerung des Leitungsdrahts - entgegenzuwirken. Bei der Kontaktierung des Leitungsdrahts mit den als Anschlussstelle vorgesehenen Bereichen des leitfähigen, dünnen Flächenelements ist es notwendig, die Beschichtung des Leitungsdrahts an der entsprechenden Stelle kurz vor der Verbindungsherstellung zu entfernen. Üblicherweise erfolgt das Entfernen der Beschichtung, d.h. das Abisolieren, durch thermisches Abschmelzen, z.B. mittels Schweißelektroden.

Ohne die Entfernung der Beschichtung würde das Schweißverfahren zur Herstellung der Verbindung nachteilig beeinflusst, was im ungünstigsten Fall zu einer unzureichenden und fehlerhaften, d.h. einer (mechanisch) nicht fixierten oder (elektrisch) nicht leitfähigen Schweißstelle führen kann. Die Entfernung der Leitungsdraht-Beschichtung ist allerdings aufwändig und verlangsamt den Prozess zur Herstellung der Leiterplatte erheblich, wodurch sich in konsequenter Weise wirtschaftliche Nachteile ergeben.

Der vorliegenden Erfindung liegt daher die Aufgabe zugrunde, eine drahtbeschriebene Leiterplatte anzugeben, welche einfacher und kostengünstiger zu realisieren ist.

Diese Aufgabe wird erfindungsgemäß gelöst durch eine drahtbeschriebene Leiterplatte gemäß Anspruch 1.

Durch den beschriebenen metallischen Aufbau des Leitungsdrahts entfällt die Notwendigkeit der Entfernung einer beispielsweise als Lack vorliegenden Beschichtung vor dem Verbinden des Leitungsdrahts mit der leitfähigen Folie. Dadurch kann die Prozessgeschwindigkeit zur Herstellung der Leiterplatte deutlich gesteigert werden. Die metallische Hülle wirkt sich dabei positiv auf die Kontaktfestigkeit und die elektrische bzw. thermische Leitfähigkeit der durch Schweißen hergestellten Verbindung aus. Gleichzeitig wird durch die Hülle der darunter liegende Metallkern wirkungsvoll vor einem oxidativen Angriff geschützt.

Es kann von Vorteil sein, dass der Kern Kupfer aufweist und vorzugsweise aus Kupfer besteht. Kupfer als ein für die Elektroindustrie seit langer Zeit bewährter Werkstoff weist eine hervorragende elektrische und thermische Leitfähigkeit auf und ist verglichen mit anderen, ähnlich gut leitenden Werkstoffen, relativ kostengünstig. Neben Kupfer sind aber auch andere Metalle wie beispielsweise Silber, Gold oder Aluminium als Kernmaterial denkbar.

Es kann zudem von Vorteil sein, dass die Hülle einlagig ist und Silber oder Zinn aufweist und vorzugsweise aus Silber oder Zinn besteht. Dieser Aufbau ist vergleichsweise einfach zu realisieren, und die Materialien Silber und Zinn besitzen vorteilhafte Eigenschaften hinsichtlich elektrischer Leitfähigkeit. Besondere Vorteile besitzen besagte Werkstoffe im Falle der Verwendung des Werkstoffs Kupfer als Kernmaterial, da sie sich relativ einfach als Beschichtungen auf Kupfer aufbringen lassen.

Ebenso kann von Vorteil sein, dass die Hülle zwei Lagen umfasst, wovon die an den Kern angrenzende Lage Silber aufweist und vorzugsweise aus Silber besteht, und die äußere Lage Zinn aufweist und vorzugsweise aus Zinn besteht. Durch diesen Aufbau ergibt sich einerseits ein wirksamer Schutz vor dem Anlaufen der Silberschicht, das in erster Linie durch Schwefelverbindungen der Luft hervorgerufen wird. Andererseits verhindert dieser Aufbau weitestgehend die Bildung von Nadelkristallen, die üblicherweise bei Zinn, insbesondere als Beschichtung auf Kupfer, auftritt.

Weiterhin kann von Vorteil sein, dass die Hülle im Wesentlichen frei von nach außen ragenden Vorsprüngen in Form von Nadelkristallen ist. Hierdurch wird ein elektrischer Kontakt und damit ein Kurzschluss bei nur geringfügig voneinander beabstandeten Leitungsdrähten oder bei einem nur sehr geringen Abstand zwischen Leitungsdraht und leitfähiger Folie vermieden. Dies ist insbesondere von Bedeutung für den Fall, dass die Hülle einlagig ist und Zinn aufweist, da Zinn - wie zuvor beschrieben - üblicherweise und insbesondere in Verbindung mit Kupfer zur Bildung von Nadelkristallen oder Whiskern neigt. Hier ist ein Zinn bzw. eine Zinnlegierung vorzusehen, welches bzw. welche keine Nadelkristalle ausbildet.

Es kann vorteilhaft sein, dass die Hülle durch eine Tauchbeschichtung aufgebracht ist. Dieses Beschichtungsverfahren ist einfach und vergleichsweise kostengünstig zu realisieren.

Zudem kann es vorteilhaft sein, dass der Kern im Querschnitt rund oder mehreckig ist. Hierdurch kann beispielsweise eine gezielte Anpassung an die geometrischen Gegebenheiten realisiert werden.

Darüber hinaus kann es vorteilhaft sein, dass das Stabilisierungsmittel mit der leitfähigen Folie nach der Drahtaufbringung vergossen oder verpresst ist. Dies erlaubt eine einfache

Aufbringung des Stabilisierungsmittels nach dem Verlegen des Leitungsdrahts bzw. der Leitungsdrähte.

Es kann sich als günstig erweisen, dass der zumindest eine Leitungsdraht wenigstens abschnittsweise in dem Stabilisierungsmittel eingebettet ist. Hierdurch ergibt sich in dem entsprechenden Bereich ein guter Schutz des Leitungsdrahts vor äußeren Einflüssen und eine stabile und dauerhafte Fixierung.

Ebenso kann sich als günstig erweisen, dass das Stabilisierungsmittel mit der leitfähigen Folie fixiert und vorzugsweise verklebt ist. Hieraus resultiert die Möglichkeit, das Stabilisierungsmittel vorab zu fertigen und mit entsprechenden Aussparungen oder Löchern für die Durchführung des Leitungsdrahts zur leitfähigen Folie zu versehen, so dass das Stabilisierungsmittel auf einfache Art und Weise, nämlich durch Verkleben, mit der leitfähigen Folie verbunden werden kann, und der Leitungsdraht bzw. die Leitungsdrähte anschließend durch die Aussparungen/Löcher mit der leitfähigen Folie verschweiß oder verlötet werden kann bzw. können. Außerdem ist denkbar, ein zum Verpressen vorgesehenes Stabilisierungsmittel zunächst nur abschnittsweise mit der leitfähigen Folie zu fixieren, um hierdurch die Montage der Leitungsdrähte zu erleichtern. Nach erfolgter Montage bei fixiertem Stabilisierungsmittel kann sodann die flächige Verbindung zwischen Stabilisierungsmittel und leitfähiger Folie durch Verpressen des Stabilisierungsmittels erzielt werden.

Es kann auch günstig sein, dass die leitfähige Folie und das mit ihr verbundene Stabilisierungsmittel durch ein RCC (Resin Coated Copper Foil) gebildet werden. Hierbei entfällt der Schritt des Verbindens des Stabilisierungsmittels mit der leitfähigen Folie, und es ergibt sich ein entsprechend vereinfachtes und weniger Schritte umfassendes Herstellungsverfahren. Die Löcher bzw. Aussparungen für die Durchführung des Leitungsdrahts zur leitfähigen Folie müssen dabei in geeigneter Weise in die Harzbeschichtung eingebracht bzw. eingearbeitet werden.

Zudem kann es günstig sein, dass der Leitungsdraht, abgesehen von dem Bereich, der zur Ausbildung einer Anschlussstelle vorgesehen ist, von der Oberfläche der leitfähigen Folie beabstandet ist. Hierdurch wird ein elektrischer Kontakt und damit die Gefahr eines Kurzschlusses zwischen dem Leitungsdraht und der leitfähigen Folie vermieden.

Die Erfindung betrifft zudem einen Leitungsdraht, insbesondere zur Verwendung in einer drahtbeschriebenen Leiterplatte, umfassend einen Kern und eine Hülle, wobei der Kern Kupfer aufweist und vorzugsweise aus Kupfer besteht und die Hülle zwei Lagen umfasst, wovon die an den Kern angrenzende Lage Silber aufweist und vorzugsweise aus Silber besteht, und die äußere Lage Zinn aufweist und vorzugsweise aus Zinn besteht.

Die Merkmale und Vorteile der Erfindung werden eingehender in der nachstehenden Beschreibung dargelegt, wobei auf die beigefügten Zeichnungen Bezug genommen wird, auf denen folgendes dargestellt ist:
- Fig. 1:: Leitungsdraht einer Ausführungsform der drahtbeschriebenen Leiterplatte im Querschnitt;
- Fig. 2:: Ausführungsform der drahtbeschriebenen Leiterplatte mit vergossenem bzw. verpresstem Stabilisierungsmittel im Querschnitt;
- Fig. 3:: Ausführungsform der drahtbeschriebenen Leiterplatte mit durch Klebemittel fixiertem Stabilisierungsmittel im Querschnitt

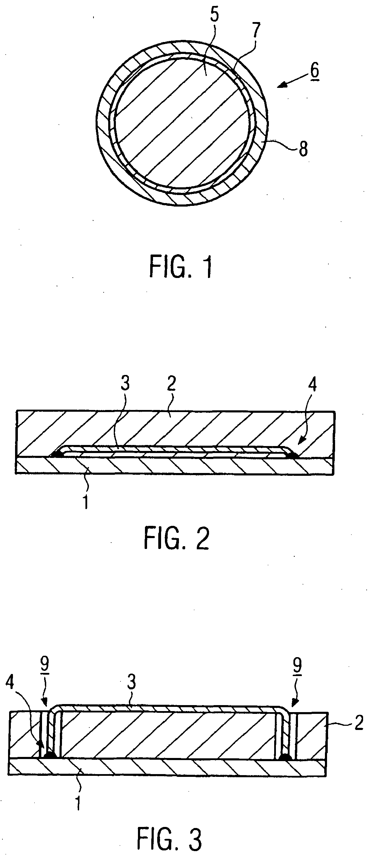

Figur 1 zeigt den Leitungsdraht einer Ausführungsform der drahtbeschriebenen Leiterplatte im Querschnitt. Der Kern 5 des Leitungsdrahts 3 besteht aus Kupfer, jedoch sind andere, elektrisch wie thermisch gut leitende Werkstoffe als Kernmaterial vorstellbar. Die Hülle 6 umfasst die zwei Lagen 7 und 8, wobei die an den Kupferkern angrenzende Lage 7 aus Silber besteht, während die zweite, äußere Lage 8 aus Zinn besteht. Vorzugsweise ist die Silberlage wesentlich dünner als die Zinnlage. Andere Metalle bzw. Metallkombinationen für die Hülle, beispielsweise eine innere Lage aus Nickel und eine äußere Lage aus Zinn, sind ebenso denkbar. Des weiteren ist denkbar, dass die Hülle mehr als zwei Lagen aufweist. Obwohl der Kern 5 und die Hülle 6 gemäß Figur 1 eine runde Form aufweisen, sind andere, beispielsweise mehreckige geometrische Formen genauso vorstellbar.

Figur 2 zeigt eine Ausführungsform der drahtbeschriebenen Leiterplatte mit vergossenem bzw. verpresstem Stabilisierungsmittel im Querschnitt. Die leitfähige Folie 1 besteht hierbei aus Kupfer. Der Leitungsdraht 3 ist zwischen zwei zur Ausbildung elektrischer Anschlussstellen vorgesehener Bereiche 4 der leitfähigen Folie 1 angeordnet und mit den Anschlussstellen elektrisch verbunden. Selbstverständlich kann der Leitungsdraht nur mit einer oder mit mehr als zwei zur Ausbildung elektrischer Anschlussstellen vorgesehener Bereich der leitfähigen Folie elektrisch verbunden sein.

Vorzugsweise hat der Leitungsdraht 3 mit der leitfähigen Folie 1 nur in den als elektrische Anschlussstellen vorgesehenen Bereichen Kontakt, dazwischen besteht kein Kontakt zwischen Leitungsdraht und leitfähiger Folie. Der Leitungsdraht ist vollständig eingebettet in ein mit der leitfähigen Folie verbundenen Stabilisierungselement. Es ist ebenso denkbar, dass der Leitungsdraht nur partiell bzw. abschnittsweise in dem Stabilisierungselement eingebettet ist.

Bei dem Stabilisierungselement 2 handelt es sich um ein mit der leitfähigen Folie nach der Drahtaufbringung verpresstes Prepreg. Ebenso kann das Stabilisierungselement auch durch ein vergossenes Material realisiert werden. Das Material des Stabilisierungselements leitet elektrischen Strom nicht bzw. sehr schlecht.

Figur 3 zeigt eine Ausführungsform der drahtbeschriebenen Leiterplatte mit durch Klebemittel fixiertem Stabilisierungsmittel im Querschnitt. Um Wiederholungen zur vorher beschriebenen Ausführungsform gemäß Figur 2 zu vermeiden, wird nur auf die Unterschiede von Figur 3 zur vorherigen Ausführungsform eingegangen.

Der Leitungsdraht 3 ist hierbei nur teilweise von dem Stabilisierungselement 2 umgeben, und zwar lediglich dort, wo der Leitungsdraht durch die Löcher 9 des mit der leitfähigen Folie 1 verklebten Stabilisierungselements hindurchragt, um an den entsprechenden Stellen mit der leitfähigen Folie elektrisch verbunden zu sein. Der übrige Bereich des Leitungsdrahts ist in Anlage mit der Oberfläche des Stabilisierungselements. Genauso gut ist es möglich, dass der Leitungsdraht in besagtem Bereich geringfügig von der Oberfläche des Stabilisierungselements beabstandet ist.

Nachfolgend wird die Wirkungs- und Funktionsweise der Erfindung näher erläutert.

Die erfindungsgemäße drahtbeschriebene Leiterplatte besitzt gegenüber bisher bekannten drahtbeschriebenen Leiterplatten den Vorteil, dass das Verbinden des Leitungsdrahts mit den als Anschlussstellen vorgesehenen Bereichen der leitfähigen Folie leichter und schneller realisiert werden kann, da die sonst übliche Entfernung der Beschichtung des Leitungsdrahts in einem zusätzlichen Verfahrensschritt entfällt.

Um den zuvor genannten Vorteil der Erfindung zu erreichen, umfasst der Leitungsdraht einen Kern und eine vorzugsweise in einem Beschichtungsverfahren aufgebrachte Hülle, wobei der Kern ein Metall aufweist und die Hülle zumindest eine Lage umfasst, die ein von dem Metall des Kerns abweichendes Metall aufweist.

Der metallische Aufbau des Leitungsdrahts erlaubt eine einfache und elektrisch bzw. thermisch wie mechanisch verlässliche Verbindung zwischen diesem und der leitfähigen Folie, und gleichzeitig schützt die mitverschweißbare Hülle den Metallkern vor oxidativem Angriff. Die Hülle kann hierbei einlagig sein und Silber oder Zinn aufweisen und vorzugsweise aus Silber oder Zinn bestehen. In einer bevorzugten Ausführungsform ist die Hülle zweilagig, wobei die an den vorzugsweise aus Kupfer bestehenden Kern angrenzende Lage Silber aufweist und die äußere Lage Zinn aufweist. In vorteilhafter Ausgestaltung besteht die an den Kern angrenzende Lage aus Silber, während die äußere Lage aus Zinn besteht.

In dem Falle, in dem die Hülle einlagig ist und Zinn aufweist, wird ein Zinn bzw. eine Zinnlegierung verwendet, welche keine oder nur sehr kleine Nadelkristalle oder Whisker ausbildet. Beim beschriebenen zweilagigen Aufbau der Hülle dient die an den vorzugsweise aus Kupfer bestehenden Metallkern angrenzende Silberschicht der Vermeidung eines direkten Kontakts zwischen Zinn und dem Kernmaterial, wodurch die Bildung von Nadelkristallen weitestgehend vermieden wird. Hierzu bedarf es einer nur sehr dünnen Silberschicht, was aus wirtschaftlicher Sicht vorteilhaft ist.

## Patentansprüche

1. Drahtbeschriebene Leiterplatte, umfassend: eine leitfähige Folie (1) mit wenigstens einem darauf befindlichen zur Ausbildung einer Anschlussstelle vorgesehenen Bereich (4), ein mit der leitfähigen Folie (1) verbundenes Stabilisierungsmittel (2) und zumindest einen Leitungsdraht (3), welcher mit dem zur Ausbildung einer Anschlussstelle vorgesehenen Bereich (4) elektrisch oder thermisch leitend verbunden ist
**dadurch gekennzeichnet,**
**dass** der Leitungsdraht (3) einen Kern (5) und eine metallische Hülle (6) umfasst, wobei der Kern ein Metall aufweist und die Hülle (6) einlagig oder zweilagig ist und die an den Kern angrenzende Lage Silber aufweist.

2. Drahtbeschriebene Leiterplatte nach Anspruch 1, **dadurch gekennzeichnet, dass** die Hülle (6) mit einem Beschichtungsverfahren auf den Kern (5) aufgebracht ist.

3. Drahtbeschriebene Leiterplatte nach Anspruch 1, **dadurch gekennzeichnet, dass** der Kern (5) Kupfer aufweist oder vorzugsweise aus Kupfer besteht.

4. Drahtbeschriebene Leiterplatte nach Anspruch 1, **dadurch gekennzeichnet, dass** die angrenzende Lage aus Silber besteht.

5. Drahtbeschriebene Leiterplatte nach Anspruch 1, **dadurch gekennzeichnet, dass** die Hülle (6) zwei Lagen (7, 8) umfasst, wovon die an den Kern angrenzende Lage (7) Silber aufweist oder vorzugsweise aus Silber besteht und die äußere Lage (8) Zinn aufweist oder vorzugsweise aus Zinn besteht.

6. Drahtbeschriebene Leiterplatte nach zumindest einem der vorangegangenen Ansprüche, **dadurch gekennzeichnet, dass** die Hülle (6) im Wesentlichen frei von nach außen ragenden Vorsprüngen in Form von Nadelkristallen ist.

7. Drahtbeschriebene Leiterplatte nach zumindest einem der vorangegangenen Ansprüche, **dadurch gekennzeichnet, dass** die Hülle (6) durch eine Tauchbeschichtung aufgebracht ist.

8. Drahtbeschriebene Leiterplatte nach zumindest einem der vorangegangenen Ansprüche, **dadurch gekennzeichnet, dass** der Kern (5) im Querschnitt rund oder mehreckig ist.

9. Drahtbeschriebene Leiterplatte nach zumindest einem der vorangegangenen Ansprüche, **dadurch gekennzeichnet, dass** der zumindest eine Leitungsdraht (3) wenigstens abschnittsweise in dem Stabilisierungsmittel (2) eingebettet ist.

10. Drahtbeschriebene Leiterplatte nach zumindest einem der vorangegangenen Ansprüche, **dadurch gekennzeichnet, dass** das Stabilisierungsmittel (2) mit der leitfähigen Folie (1) fixiert ist, vorzugsweise verklebt ist oder nach der Drahtaufbringung vergossen oder verpresst ist.

11. Drahtbeschriebene Leiterplatte nach zumindest einem der vorangegangenen Ansprüche, **dadurch gekennzeichnet, dass** die leitfähige Folie (1) und das mit ihr verbundene Stabilisierungsmittel (2) durch ein RCC gebildet werden.

12. Drahtbeschriebene Leiterplatte nach zumindest einem der vorangegangenen Ansprüche, **dadurch gekennzeichnet, dass** der Leitungsdraht (3), abgesehen von dem Bereich (4), der zur Ausbildung einer Anschlussstelle vorgesehen ist, von der Oberfläche der leitfähigen Folie (1) beabstandet ist.

13. Leitungsdraht zur Verwendung in einer drahtbeschriebenen Leiterplatte, umfassend einen Kern (5) und eine metalische Hülle (6), wobei der Kern Kupfer aufweist, und die Hülle zwei Lagen (7, 8) umfasst, wovon die an den Kern angrenzende Lage (7) Silber aufweist, und die äußere Lage (8) Zinn aufweist.

14. Leitungsdraht nach Anspruch 13 zur Verwendung in einer drahtbeschriebenen Leiterplatte **dadurch gekennzeichnet, dass** der Kern aus Kupfer besteht oder die an den Kern angrenzende Lage (7) aus Silber besteht oder die äußere Lage (8) aus Zinn besteht.

## Claims

1. Wire-inscribed conductor board, comprising: a conductive foil (1) with at least one provided area (4) for forming a connection point, a stabilizing means (2) which is connected with the conductive foil (1) and at least one conductive wire (3), which is electrically or thermically conductively connected with the provided area (4) for forming a connection point,
**characterized in that**
the conductive wire (3) comprises a core (5) and a metallic sheath (6), wherein the core comprises a metal and the sheath (6) is single layered or double layered, and the layer adjacent to the core comprises silver.

2. Wire-inscribed conductor board according to claim 1, **characterized in that** the sheath (6) is applied on the core (5) by a coating process.

3. Wire-inscribed conductor board according to claim 1, **characterized in that** the core (5) comprises copper or preferably consists of copper.

4. Wire-inscribed conductor board according to claim 1, **characterized in that** the layer adjacent consists of silver.

5. Wire-inscribed conductor board according to claim 1, **characterized in that** the sheath (6) comprises two layers (7, 8), wherein the layer adjacent to the core comprises silver or preferably consists of silver, and the outer layer (8) comprises tin or preferably consists of tin.

6. Wire-inscribed conductor board according to at least one of the preceding claims, **characterized in that** the sheath (6) is substantially free from projections that protrude outwards in a shape of whiskers.

7. Wire-inscribed conductor board according to at least one of the preceding claims, **characterized in that** the sheath (6) is applied by dip coating.

8. Wire-inscribed conductor board according to at least one of the preceding claims, **characterized in that** the core (5) is round or polygonal in its cross-section.

9. Wire-inscribed conductor board according to at least one of the preceding claims, **characterized in that** the at least one conductive wire (3) is implemented in the stabilizing means (2) at least in sections.

10. Wire-inscribed conductor board according to at least one of the preceding claims, **characterized in that** the stabilizing means (2) is fixed with the conductive foil (1), is preferably glued thereon or is casted or grouted after the wire inscription.

11. Wire-inscribed conductor board according to at least one of the preceding claims, **characterized in that** the conductive foil (1) and the connected stabilizing means (2) connected thereon is an RCC.

12. Wire-inscribed conductor board according to at least one of the preceding claims, **characterized in that** the conductive wire (3) is distant from the surface of the conductive foil (1) with the exception of the provided area (4) for forming a connection point.

13. Conductive wire for use in a wire-inscribed conductor board, comprising a core (5) and a metal sheath (6), wherein the core comprises copper, and the sheath comprises two layers (7, 8), wherein the layer (7) adjacent to the core comprises silver and the outer layer (8) comprises tin.

14. Conductive wire according to claim 13 for use in a wire-inscribed conductor board, **characterized in that** the core consists of copper or the layer (7) adjacent to the core consists of silver or the outer layer (8) consists of tin.

## Revendications

1. Plaque de circuit imprimé à pistes décrites par fils, comportant : une feuille conductrice (1) sur laquelle se trouve au moins une zone (4) prévue pour réaliser un point de connexion, un moyen de stabilisation (2) relié à la feuille conductrice (1), et au moins un fil conducteur (3), qui est relié à la zone (4) prévue pour réaliser un point de connexion par une liaison conductrice sur le plan électrique ou thermique,
**caractérisée**
**en ce que** le fil conducteur (3) comporte une âme (5) et une enveloppe métallique (6), l'âme comprenant un métal et l'enveloppe (6) étant d'une configuration à une couche ou plusieurs couches, et la couche adjacente à l'âme comprenant de l'argent.

2. Plaque de circuit imprimé à pistes décrites par fils selon la revendication 1, **caractérisée en ce que** l'enveloppe (6) est appliquée sur l'âme (5) par un procédé de revêtement.

3. Plaque de circuit imprimé à pistes décrites par fils selon la revendication 1, **caractérisée en ce que** l'âme (5) comprend du cuivre ou est de préférence constituée de cuivre.

4. Plaque de circuit imprimé à pistes décrites par fils selon la revendication 1, **caractérisée en ce que** ladite couche adjacente est constituée d'argent.

5. Plaque de circuit imprimé à pistes décrites par fils selon la revendication 1, **caractérisée en ce que** l'enveloppe (6) comporte deux couches (7, 8) dont la couche (7) adjacente à l'âme comprend de l'argent ou est de préférence constituée d'argent, et dont la couche extérieure (8) comprend de l'étain ou est de préférence constituée d'étain.

6. Plaque de circuit imprimé à pistes décrites par fils selon l'une au moins des revendications précédentes, **caractérisée en ce que** l'enveloppe (6) est sensiblement exempte de protubérances faisant saillie vers l'extérieur sous la forme de cristaux en aiguilles.

7. Plaque de circuit imprimé à pistes décrites par fils selon l'une au moins des revendications précédentes, **caractérisée en ce que** l'enveloppe (6) est appliquée par un procédé de revêtement par immersion.

8. Plaque de circuit imprimé à pistes décrites par fils selon l'une au moins des revendications précédentes, **caractérisée en ce que** l'âme (5) est d'une section transversale ronde ou polygonale.

9. Plaque de circuit imprimé à pistes décrites par fils selon l'une au moins des revendications précédentes, **caractérisée en ce que** ledit au moins un fil conducteur (3) est encastré ou noyé au moins par tronçons dans le moyen de stabilisation (2).

10. Plaque de circuit imprimé à pistes décrites par fils selon l'une au moins des revendications précédentes, **caractérisée en ce que** le moyen de stabilisation (2) est fixé à la feuille conductrice (1), de préférence collé, ou est lié par moulage ou compression après l'application du fil.

11. Plaque de circuit imprimé à pistes décrites par fils selon l'une au moins des revendications précédentes, **caractérisée en ce que** la feuille conductrice (1) et le moyen de stabilisation (2) qui y est lié, sont formés par un feuillard de cuivre revêtu de résine dit RCC (Resin Coated Copper foil).

12. Plaque de circuit imprimé à pistes décrites par fils selon l'une au moins des revendications précédentes, **caractérisée en ce que** le fil conducteur (3) est, exception faite de la zone (4) prévue pour réaliser un point de connexion, espacé de la surface de la feuille conductrice (1).

13. Fil conducteur destiné à être utilisé dans une plaque de circuit imprimé à pistes décrites par fils, comportant une âme (5) et une enveloppe métallique (6), l'âme comprenant du cuivre, et l'enveloppe comportant deux couches (7, 8), dont la couche (7) adjacente à l'âme comprend de l'argent et dont la couche extérieure (8) comprend de l'étain.

14. Fil conducteur selon la revendication 13, **caractérisé en ce que** l'âme est constituée de cuivre, ou la couche (7) adjacente à l'âme est constituée de cuivre, ou la couche extérieure (8) est constituée d'étain.
